(19) Europäisches Patentamt

European Patent Office

Office européen des brevets

(11) **EP 0 521 315 B1**

(12) **EUROPÄISCHE PATENTSCHRIFT**

(45) Veröffentlichungstag und Bekanntmachung des Hinweises auf die Patenterteilung:
**07.05.1997 Patentblatt 1997/19**

(51) Int Cl.[6]: **H03M 1/12**, H03M 3/02

(21) Anmeldenummer: **92109630.1**

(22) Anmeldetag: **09.06.1992**

(54) **Verfahren und Anordnung zur Verarbeitung von Bandpasssignalen**

Method and arrangement for processing bandpass signals

Procédé et agencement de traitement de signaux de bande-passante

(84) Benannte Vertragsstaaten:
**AT BE CH DE DK ES FR GB IT LI NL SE**

(30) Priorität: **19.06.1991 DE 4120160**

(43) Veröffentlichungstag der Anmeldung:
**07.01.1993 Patentblatt 1993/01**

(73) Patentinhaber: **AEG MOBILE COMMUNICATION GmbH**
**D-89081 Ulm (DE)**

(72) Erfinder:
• **Dressler, Hans-Joachim, Dipl.-Ing.**
**W-7909 Dornstadt (DE)**
• **Lipp, Ingo, Dipl.-Ing.**
**W-5552 Morbach (DE)**

(74) Vertreter: **Körner, Ekkehard, Dipl.-Ing.**
**Patentanwalt**
**Maximilianstrasse 58**
**80538 München (DE)**

(56) Entgegenhaltungen:
**WO-A-82/04508**

• **SIGNAL PROCESSING Bd. 22, Nr. 2 , Februar 1991 , AMSTERDAM NL Seiten 139 - 151 XP000208672 DRESSLER 'Interpolative bandpass-A/D-Conversion'**
• **IBM TECHNICAL DISCLOSURE BULLETIN Bd. 32, Nr. 4B , September 1989 , ARMONK, NY, US Seiten 419 - 421 XP000066925 'Sigma-Delta ADC Dynamic Range Improvement'**

## Beschreibung

Die Erfindung betrifft ein Verfahren und eine Anordnung zur interpolativen analog-digitalen Umsetzung von Bandpaßsignalen nach den Oberbegriffen der Patentansprüche 1 und 6.

Derartige interpolative A/D-Umsetzer für Bandpaßsignale finden insbesondere beim Mobilfunk Verwendung.

In der nicht vorveröffentlichten deutschen Patentanmeldung P 39 43 072 (mit der Internationalen Veröffentlichungsnummer WO 91/10283) wird ein interpolativer A/D-Umsetzer zur Verarbeitung von Bandpaßsignalen beschrieben. Fig. 1 zeigt den Eingangsteil des A/D-Umsetzers, die analog-digitale Modulatorschleife. Sie ist ein Regelkreis bestehend aus einem grob quantisierenden A/D-Umsetzer, einem D/A-Umsetzer entsprechender Auflösung, Vergleichsstellen, linearen Netzwerken H(p) und Koeffizientengliedern $a_i$, $b_i$. Die A/D-und D/A-Umsetzer werden mit der Taktfrequenz $f_a$ betrieben. Die speziellen Übertragungseigenschaften der Modulatorschleife erlauben die Verwendung von 1 bit A/D- bzw. 1 bit D/A-Umsetzern bei insgesamt hoher Auflösung der Gesamtstruktur. Diese Robustheit gegen Quantisierungsfehler an der Analog-Digital-Schnittstelle erleichtert die monolithische Integration erheblich, ganz im Gegensatz zu nicht interpolativen Techniken mit vergleichbarer Auflösung.

Die mit der beschriebenen Struktur erreichbare Arbeitsgeschwindigkeit wird maßgeblich durch unvermeidliche Schleifenlaufzeiten bestimmt. Im folgenden wird gezeigt, daß ohne besondere schaltungstechnische Maßnahmen bei der 1 bit D/A-Umsetzung bereits geringe Schleifenlaufzeiten zu erheblichen Implementierungsverlusten, im Extremfall sogar zu Instabilität führen.

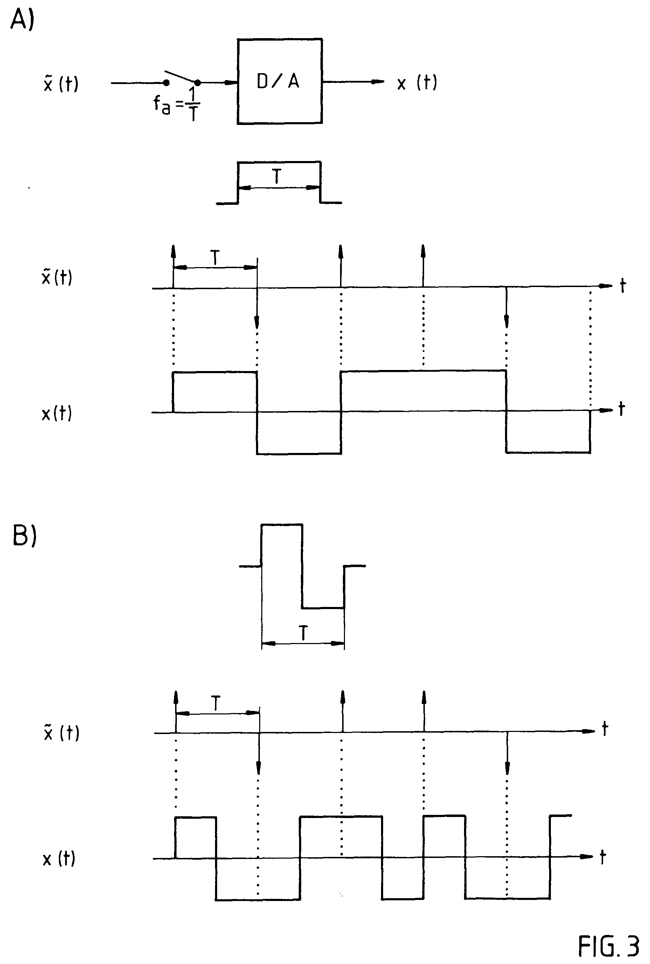

Reale D/A-Umsetzer besitzen üblicherweise rechteckfömiges Interpolationsverhalten: Das als Impulsfolge darstellbare Digitalsignal am Eingang des D/A-Umsetzers wird durch den D/A-Umsetzer rechteckförmig interpoliert (Fig. 3a). Es entsteht eine Rechteckimpulsfolge. Im Falle der hier interessierenden 1 bit D/A-Umsetzung kommt es je nach Vorzeichen des Eingangsimpulses zur Ausgabe eines positiven oder negativen Rechteckimpulses der Dauer T, wobei T die Periodendauer des Abtasttaktes bezeichnet. In der Praxis werden zur Vermeidung von Impulsübersprechen auch verkürzte Rechteckimpulse oder gezielt abgerundete Impulse eingesetzt. An der Problematik der Schleifenverzögerung ändert diese Art der Impulsformung allerdings nichts, so daß die Struktur mit Rechteckinterpolation in der Rückkopplung diesbezüglich den Stand der Technik repräsentiert.

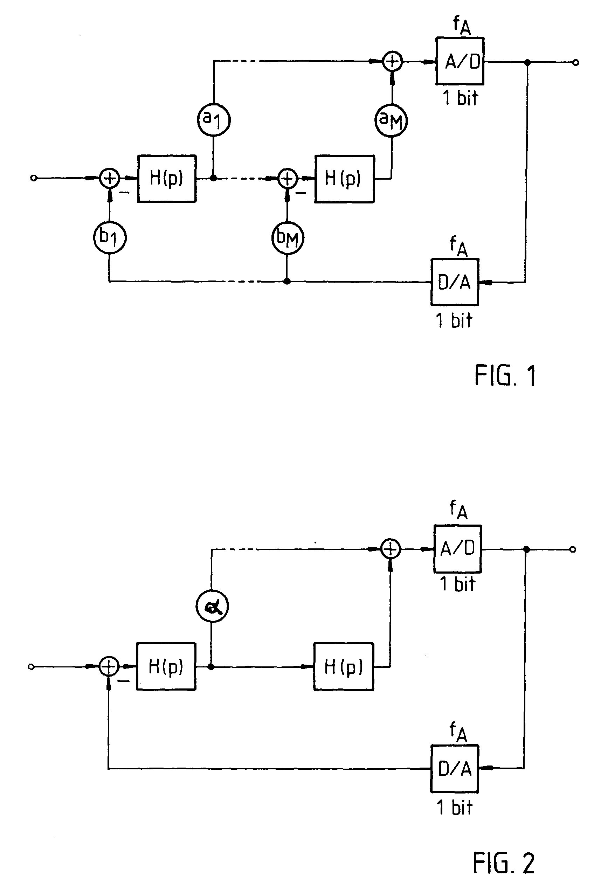

Der Einfluß der Schleifenlaufzeit auf die Signalauflösung wird im folgenden am Beispiel einer Struktur mit zwei Bandpaß-Integratoren veranschaulicht. Die Struktur mit zwei Bandpaß-Integratoren, wie sie FIG. 2 wiedergibt, wird in der Praxis bevorzugt eingesetzt. Sie bietet gegenüber der Struktur mit einem Bandpaß-Integrator den Vorteil eines deutlich verbesserten Rauschverhaltens und gegenüber Strukturen mit mehr als zwei Bandpaß-Integratoren den Vorteil der Unempfindlichkeit gegenüber größeren Prozeßparameterschwankungen bei monolithischer Integration.

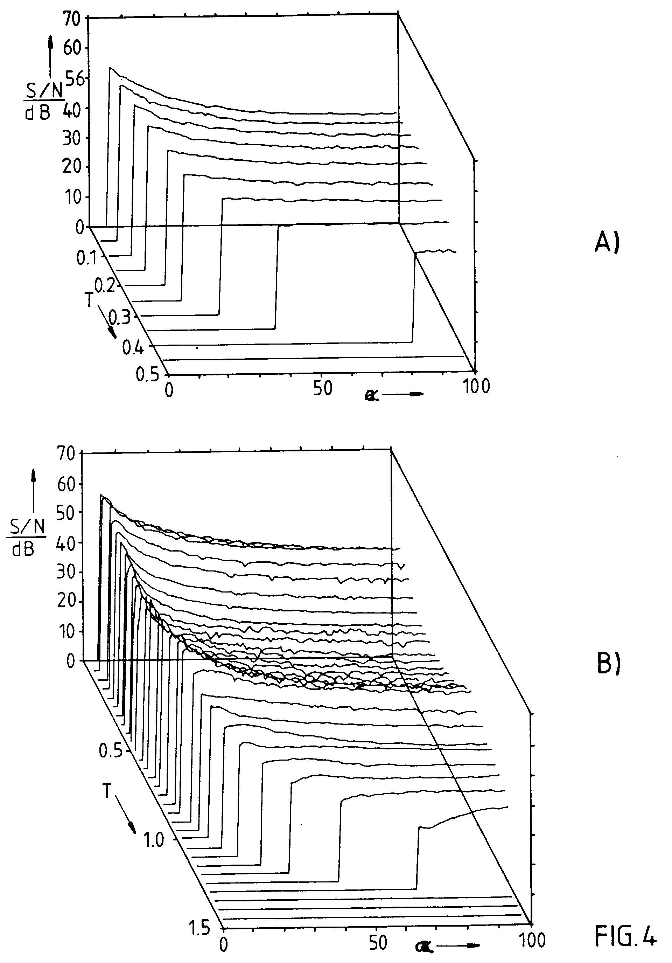

Für die Struktur mit Rechteckinterpolation zeigt FIG. 4a den Einfluß der relativen Schleifenlaufzeit $\tau$ (= absolute Schleifenlaufzeit bezogen auf die Periodendauer des Abtasttaktes) auf die Signalauflösung der Gesamtstruktur für verschiedene Werte des Steuerparameters $\alpha$. Aufgrund von FIG. 4a lassen sich folgende Aussagen machen: Für $\alpha = O$ arbeitet die Regelschleife selbst bei idealem Bauelementeverhalten ($\tau = O$) instabil. Erst ab einem gewissen, von der Schleifenlaufzeit abhängigen Wert $\alpha > O$ stellt sich Stabilität ein. Der unmittelbar am Stabilitätsrand erreichbare Signal-Rauschabstand nimmt mit zunehmender Schleifenlaufzeit deutlich ab. Für $\tau \geq 0,5$ ist der Regelkreis durch $\alpha$ nicht mehr stabilisierbar.

Der Erfindung liegt deshalb die Aufgabe zugrunde die Empfindlichkeit der analog-digitalen Modulatorschleife gegenüber realisierungsbedingten Schleifenlaufzeiten zu verbessern, was insbesondere für hochfrequente Anwendungen von Bedeutung ist.

Die Aufgabe wird gelöst durch die im kennzeichnenden Teil der Patentansprüche 1 und 6 angegebenen Merkmale. Vorteilhafte Ausgestaltungen und Weiterbildungen sind den Unteransprüchen zu entnehmen.

Die Erfindung wird nachfolgend anhand eines Ausführungsbeispiels beschrieben unter Bezugnahme auf schematische Zeichnungen.

Zur Verbesserung des Systemverhaltens bei Schleifenverzögerung wird vorgeschlagen, die Interpolationsfunktion des D/A-Umsetzers, wie in FIG. 3b gezeigt, zu modifizieren. Man spricht in diesem Fall von Biphasen-Interpolation. Welche Verbesserungen sich damit quantitativ erzielen lassen, zeigt FIG. 4b: Es werden Verzögerungszeiten bis zum 1,5fachen der Schleifentaktperiode toleriert. Der Signal-Rauschabstand ist insgesamt besser als im Fall der Rechteck-Interpolation.

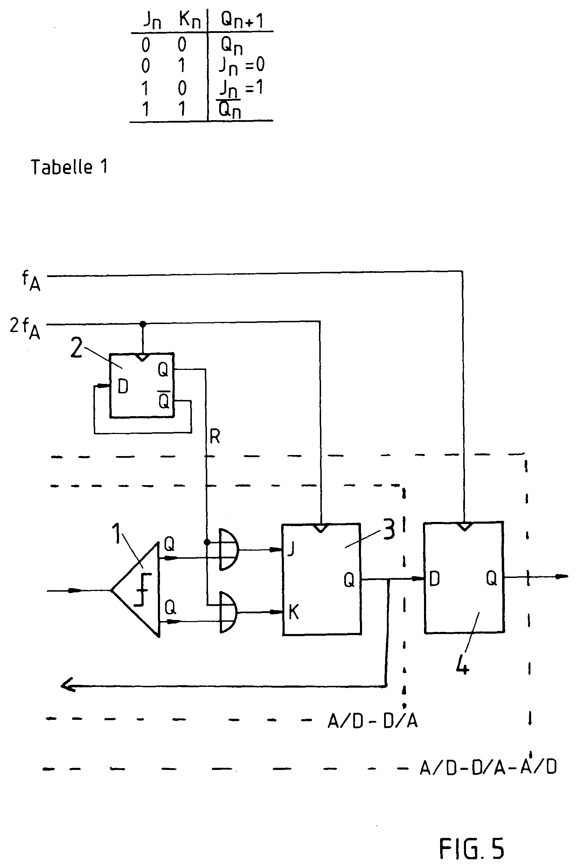

In FIG. 5 ist dargestellt, wie sich die Biphasen-Interpolation aufwandsgünstig realisieren läßt. Um zusätzliche Verzögerungszeiten zur Durchführung der Interpolation zu vermeiden, wurden A/D- und D/A-Umsetzer der analog-digitalen Modulatorschleife miteinander kombiniert. Als 1 bit Quantisierer dient ein Komparator 1 mit den differentiell arbeitenden Logikausgängen Q und $\bar{Q}$. Das als Toggle-Flipflop beschaltete erst D-Flipflop 2 erzeugt ein alternierendes Rechtecksignal R, das die Perioden Dauer $T = 1/f_a$ besitzt. Durch ODER-Verknüpfung der Komparatorausgangssignale Q und $\bar{Q}$ mit dem alternierenden Rechtecksignal R entsteht schließlich das Signalpaar (J,K) zur Ansteuerung des eigentlichen Abtast-Flipflops 3. Es handelt sich hierbei um ein Flipflop vom Typ JK, das ebenso wie das Toggle-Flipflop mit der zweifachen Taktfrequenz $2f_a$ betrieben

wird. Tabelle 1 zeigt die Wahrheitstabelle des JK-Flipflops, auf die im weiteren Verlauf noch mehrfach Bezug genommen wird.

Die beiden zwischen Komparator und Toggle-Flipflop befindlichen ODER Gatter arbeiten hier wie ein Tor, das abhängig vom Logikpegel des alternierenden Rechtecksignals periodisch mit der Frequenz $f_a$ geöffnet bzw. geschlossen wird. In der durch R = "Low" gekennzeichneten Halbperiode ist das Tor geöffnet, d.h. es gilt J:= Q und K:= $\overline{Q}$. J und K haben in diesem Fall unterschiedliche Logikpegel und es gilt laut Wahrheitstabelle $Q_{n+1} := J_n$. Der von dem Komparator erzeugte Logikpegel wird also vom JK-Flipflop erfaßt.

In der nachfolgenden, durch R = "High" gekennzeichneten Halbperiode ist das Tor geschlossen. Aufgrund der ODER Verknüpfung gilt

J := "High"

und

K := "High".

Laut Wahrheitstabelle führt dies zu einem Kippvorgang am Ausgang des JK-Flipflops und damit zur Erzeugung eines Biphasenimpulses. Das Ausgangssignal des JK-Flipflops ist demzufolge als Ausgangssignal eines 1 bit D/A-Umsetzers mit Biphasen-Interpolation interpretierbar.

Zur Weiterverarbeitung des 1 bit Signals im Digitalteil ist die Schaltung durch ein zweites D-Flipflop 4 ergänzt, womit das Biphasensignal während der ersten Halbperiode mit der Frequenz $f_a$ abgetastet wird. Hinsichtlich des Pfades Komparator → JK-Flipflop → zweites D-Flipflop arbeitet die Anordnung als 1 bit A/D-D/A-A/D-Umsetzer.

## Patentansprüche

1. Verfahren zur digital-analogen Umsetzung im Rückwärtszweig einer analog-digitalen Modulatorschleife eines interpolativen Bandpaß-A/D-Umsetzer, dadurch gekennzeichnet, daß die D/A-Umsetzung durch Biphasen-Interpolation erreicht wird.

2. Verfahren nach Anspruch 1, dadurch gekennzeichnet,

   - daß in einem Komparator (1) die Signale Q, $\overline{Q}$ erzeugt werden,
   - daß über ein erstes D-Flipflop (2) ein alternierendes Rechtecksignal R hergestellt wird,
   - daß durch ODER-Verknüpfung der Komparatorausgangssignale Q, $\overline{Q}$ mit dem alternierenden Rechtecksignal R ein Signalpaar J, K zur Ansteuerung eines JK-Flipflop (3) erzeugt wird,
   - daß am Ausgang des JK-Flipflop (3) ein biphaseninterpoliertes Signal erzeugt wird, und
   - daß das biphasen-interpolierte Signal über ein zweites D-Flipflop (4) weiterverarbeitet wird.

3. Verfahren nach Anspruch 2, dadurch gekennzeichnet,

   - daß das erste D-Flipflop (2) als Toggle-Flipflop beschaltet und mit der zweifachen Taktfrequenz 2 $f_a$ betrieben wird, und
   - daß mit dem ersten D-Flipflop (2) ein alternierendes Rechtecksignal R der Periodendauer 1/$f_a$ erzeugt wird.

4. Verfahren nach Anspruch 2, dadurch gekennzeichnet, daß das JK-Flipflop (3) mit der zweifachen Taktfrequenz 2 $f_a$ betrieben wird.

5. Verfahren nach Anspruch 2, dadurch gekennzeichnet,

   - daß über das zweite D-Flipflop (4) das Biphasensignal während der ersten Halbperiode mit der Taktfrequenz $f_a$ abgetastet wird.

6. Schaltungsanordnung zur Durchführung eines Verfahrens nach einem der vorhergehenden Ansprüche zur digital-analogen Umsetzung im Rückwärtszweig einer analog-digitalen Modulatorschleife eines interpolativen Bandpaß-A/D-Umsetzer, dadurch gekennzeichnet, daß zur D/A-Umsetzung ein Biphasen-Interpolator verwendet wird, bei dem

   - zwischen einem Komparator (1) und einem JK-Flipflop (3) ein ODER-Gatter geschaltet ist, das über ein alternierendes Rechtecksignal eines ersten D-Flipflop (2) steuerbar ist, und
   - daß ein zweites D-Flipflop (4) dem JK-Flipflop (3) nachgeschaltet ist.

## Claims

1. A method for the digital-to-analog conversion in the feedback branch of an analog-to-digital modulator loop of an interpolative band pass A/D converter, characterized in that the D/A conversion is achieved by biphase interpolation.

2. A method according to claim 1, characterized in that

   - the signals Q, $\overline{Q}$ are generated in a comparator (1),
   - an alternating rectangular signal R is generated through a first D flip-flop (2),
   - a signal pair J, K for controlling a JK flip-flop (3) is generated by the OR-linkage of the comparator output signals Q, $\overline{Q}$ with the alternating rectangular signal R,
   - a biphase interpolated signal is generated at the output of the JK flip-flop (3), and
   - that the biphase interpolated signal is further processed through a second D flip-flop (4).

3. A method according to claim 2, characterized in that

- the first D flip-flop (2) is connected as a toggle flip-flop and is operated with twice the pulse frequency 2 $f_a$, and
- that an alternating rectangular signal R of the period duration 1/$f_a$ is generated by the first D flip-flop (2).

4. A method according to claim 2, characterized in that the JK flip-flop (3) is operated at twice the clock frequency 2 $f_a$.

5. A method according to claim 2, characterized in that

- the bi-phase signal is sampled through the second D-flipflop during the first half period by the clock frequency $f_a$.

6. A circuit arrangement for executing a method according to one of the preceding claims for the digital-to analog conversion in the feedback branch of an analog-to-digital bandpass A/D converter, characterized in that

- a biphase interpolator is used for the D/A conversion, in which an OR-gate is connected between a comparator (1) and a JK flip-flop (3), said OR-gate being controllable through an alternating rectangular signal of a first D flip-flop (2), and
- that a second D flip-flop (4) is connected downstream the JK flip-flop (3).

**Revendications**

1. Procédé de conversion numérique-analogique dans une branche à lecture arrière d'une boucle de modulateur analogique-numérique d'un convertisseur A/N à bande-passante interpolatif, caractérisé en ce que la conversion N/A est obtenue par interpolation biphasée.

2. Procédé selon la revendication 1, caractérisé

- en ce qu'on génère dans un comparateur (1) les signaux Q et $\overline{Q}$,

- en ce qu'on établit un signal rectangulaire R alternatif, par l'intermédiaire d'une première bascule D (2),

- en ce que, par une combinaison logique OU des signaux de sortie du comparateur Q, $\overline{Q}$, avec le signal rectangulaire alternatif R, on génère une paire de signaux J, K destinés à l'attaque d'une bascule JK (3),

- en ce qu'on génère un signal biphasé interpolé à la sortie de la bascule JK (3), et

- en ce que l'on retraite le signal biphasé interpolé par l'intermédiaire d'une deuxième bascule D (4).

3. Procédé selon la revendication 2, caractérisé

- en ce que la première bascule D (2) est branchée en bascule à changement d'état et fonctionne à une fréquence de cadencement double 2 $f_a$, et

- en ce qu'avec la première bascule D (2) est généré un signal rectangulaire alternatif R de durée de période 1/$f_a$.

4. Procédé selon la revendication 2, caractérisé en ce que la bascule JK (3) fonctionne à la fréquence de cadencement double 2 $f_a$.

5. Procédé selon la revendication 2, caractérisé

- en ce que, par l'intermédiaire de la deuxième bascule D (4), on explore le signal biphasé pendant la première demi-période, à la fréquence de cadencement $f_a$.

6. Circuit de mise en oeuvre d'un procédé selon l'une des revendications précédentes, pour effectuer la conversion numérique-analogique dans une branche à fonctionnement en arrière d'une boucle de modulateur analogique-numérique d'un convertisseur A/N à bande-passante interpolatif, caractérisé en ce que, pour assurer la conversion N/A, on utilise un interpolateur biphasé, pour lequel

- entre un comparateur (1) et une bascule JK (3) est branchée une porte logique OU qui peut être commandée par l'intermédiaire d'un signal rectangulaire alternatif d'une première bascule D (2), et

- en ce qu'une deuxième bascule D (4) est branchée en aval de la bascule JK (3).

FIG. 1

FIG. 2

A)

B)

FIG. 3

6

A)

B)

FIG. 4

| $J_n$ | $K_n$ | $Q_{n+1}$ |
|-------|-------|-----------|
| 0 | 0 | $Q_n$ |
| 0 | 1 | $J_n = 0$ |
| 1 | 0 | $J_n = 1$ |
| 1 | 1 | $\overline{Q_n}$ |

Tabelle 1

FIG. 5